(19) Europäisches Patentamt
European Patent Office
Office européen des brevets

(11) **EP 2 246 898 A1**

(12) **EUROPEAN PATENT APPLICATION**
published in accordance with Art. 153(4) EPC

(43) Date of publication:
**03.11.2010 Bulletin 2010/44**

(51) Int Cl.:
*H01L 31/04* [(2006.01)]

(21) Application number: **09707196.3**

(22) Date of filing: **03.02.2009**

(86) International application number:
**PCT/JP2009/051804**

(87) International publication number:
**WO 2009/099071 (13.08.2009 Gazette 2009/33)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **04.02.2008 JP 2008024227**

(71) Applicant: **The University of Tokyo Bunkyo-Ku Tokyo 113-8654 (JP)**

(72) Inventors:
• **WADA, Kazumi Tokyo 113-8654 (JP)**
• **ICHIKAWA, Ryuzo Tokyo 113-8654 (JP)**

(74) Representative: **Michalski Hüttermann & Partner Patentanwälte Neuer Zollhof 2 40221 Düsseldorf (DE)**

(54) **SILICON SOLAR CELL**

(57) The present invention provides a silicon solar cell including numbers of scatterers 12 in a silicon substrate 10 of a pn junction structure where an n-type silicon substrate is formed on a p-type silicon substrate by diffusion of n-type impurities. The scatterers 12 scatter, upon irradiation of incident light 11, the irradiated light in all directions, as shown by a plurality of arrows 11a to 11g. Since scattered lights caused by the scatterers 12 travel in a long-length direction along a light-receiving surface 10a, a light pass-through length increases correspondingly, increasing light absorption. Even with holes (pipe-like holes) made in the light-receiving surface 10a of the silicon substrate 10 after an anodic oxidation process, as with a silicon substrate 10 having air spheres 12, a light internal survival rate is increased more than that of a normal silicon substrate. By a simpler manufacturing method where an annealing process is omitted, a silicon substrate having a light internal survival rate comparable with that of a silicon substrate having air spheres is manufactured.

FIG. 1

11 INCIDENT LIGHT    10 SILICON SUBSTRATE

12 SCATTERER (AIR SPHERE)

EP 2 246 898 A1

**Description**

TECHNICAL FIELD

The present invention relates to a silicon solar cell that converts light energy into electrical energy using crystalline or amorphous silicon (Si).

BACKGROUND ART

Generally, a silicon solar cell forms a pn junction structure where an n layer is formed on a surface layer of a p-type silicon substrate by diffusion of n-type impurities, and has a negative electrode on the n layer serving as a light-receiving surface, and a positive electrode on a p$^+$ layer formed on a surface opposite to the light-receiving surface by diffusion of high concentration p-type impurities. In this configuration, when sunlight is incident on the light-receiving surface, the incident light is absorbed by silicon. Then, by optical excitation caused at this time, a photoelectromotive force is generated at a pn junction surface, whereby a current is supplied to a load such as a motor through the two electrodes.

Meanwhile, the band gap of crystalline silicon is 1.12 eV. When crystalline silicon is used in a solar cell, the solar cell can absorb light ranging from the near-ultraviolet region to on the order of 1.2 $\mu$m and generate electricity. However, since crystalline silicon is an indirect transition semiconductor, the light absorption coefficient is low and thus a silicon layer on the order of 200 $\mu$m at minimum is required to obtain a practical amount of absorption. However, in recent years, light-trapping techniques have been developed that use, for example, an anti-reflection film in which a transparent thin-film having a refractive index between the refractive index of silicon and the refractive index of air is formed on a light-receiving surface to suppress light reflection at the light-receiving surface using light interference by the film, or a projected and recessed surface structure in which a light-receiving surface is subjected to anisotropic etching to form projections and recesses on a surface and by the projections and the recesses, the number of times light is incident is increased and transmission from the inside to the outside of a silicon layer is prevented. By this, formation of a silicon layer in a thin film form is achieved.

For silicon solar cells of this type, there are solar cells described in Patent Documents 1 and 2. In a solar cell in Patent Document 1, a semiconductor layer of a first conductive type and a semiconductor layer of a second conductive type are stacked on top of each other, and at least one of the semiconductor layer of the first conductive type and the semiconductor layer of the second conductive type has a refractive index distribution structure. The refractive index distribution structure is configured by a plurality of layers or a plurality of phases having a non-flat boundary. Furthermore, at least one of the plurality of layers or the plurality of phases is an island-like crystal formed on a flat surface. Furthermore, the plurality of layers or the plurality of phases has a dappled pattern. By such a refractive index distribution structure, incident light is scattered to increase an optical path length. By this, the effective light absorption coefficient is increased, improving photoelectric conversion efficiency.

A solar cell in Patent Document 2 has a first electrode; a second electrode placed to face the first electrode and having a catalyst layer on a surface thereof; an electron transport layer which is located between the first electrode and the second electrode, and at least part of which is porous; a dye layer which comes into contact with the electron transport layer; and a positive hole transport layer located so as to be in contact with the electron transport layer and the catalyst layer formed on the surface of the second electrode. The positive hole transport layer is formed by applying a positive hole transport layer material onto the dye layer by a coating method. In addition, the electron transport layer is porous, which has, as can be seen from the contents and drawings of Patent Document 2, a structure in which elongated, winding, and cave-like holes (thin holes) are made roughly in a thickness direction of the solar cell (silicon layer).

In such a configuration, light that is incident from the outside and passes through a barrier layer penetrates inside the electron transport layer and transmits through the electron transport layer or is reflected (irregularly reflected, diffused, etc.) in the holes in any direction. At this time, by the light coming into contact with the dye layer, electrons and positive holes are generated with high frequency. By this, the effective light absorption coefficient is increased, improving photoelectric conversion efficiency.

Patent Document 1: Japanese Patent Application Laid-Open No. 2006-229133
Patent Document 2: Japanese Patent Application Laid-Open No. 2003-331937
Non-Patent Document 1: S.M. Sze, Physics of Semiconductor Devices John Wiley and Sons, New York, 1969, p.370.

DISCLOSURE OF THE INVENTION

PROBLEMS TO BE SOLVED BY THE INVENTION

Meanwhile, in the above-described conventional light-trapping techniques such as an anti-reflection film and a projected and recessed surface structure, incident light is reflected at the anti-reflection film or surface projections and recesses in a direction oblique to an axis in a thickness direction of a silicon layer. However, when the silicon layer is formed in a thin film form, a light pass-through length after the reflection decreases. As a result, the overall light pass-through length after incidence decreases and thus absorption of light is not performed sufficiently, causing a problem that photoelectric conversion efficiency also decreases.

In Patent Document 1, incident light is reflected in a direction oblique to an axis in a thickness direction of a silicon layer by means of a refractive index distribution structure. However, in this configuration, too, when a thin film form is implemented, as with the above, the light pass-through length decreases and thus absorption of light is not performed sufficiently, causing a problem that photoelectric conversion efficiency also decreases.

In Patent Document 2, incident light is reflected obliquely at wall surfaces of thin holes which are made in an elongated, winding, and cave-like manner roughly in a thickness direction of a silicon layer. However, in this configuration, too, when a thin film form is implemented, as with the above, the light pass-through length decreases and thus absorption of light is not performed sufficiently, causing a problem that photoelectric conversion efficiency also decreases.

To solve the above-described problem, an object of the present invention is to increase the light pass-through length after incidence even if a silicon layer is formed in a thin film form, so that light absorption can be increased, whereby photoelectric conversion efficiency is improved.

MEANS FOR SOLVING PROBLEM

To attain the above-described object, the inventors provide a scatterer that scatters incident light in all directions, in a silicon substrate of a pn junction structure.

Specifically, a silicon solar cell having a silicon substrate of a pn junction structure that converts incident light into electric power includes: a scatterer that scatters incident light in all directions, in the silicon substrate.

According to this configuration, by allowing incident light to be scattered by the scatterer, the incident light can be guided in all directions in the silicon substrate, as scattered lights. At this time, since scattered lights travel in a long-length direction along a light-receiving surface for the incident light, the light pass-through length increases correspondingly, enabling to increase light absorption. By this, photoelectric conversion efficiency can be improved.

In the silicon solar cell of the present invention, it is desirable that the scatterer be a cavity.

According to this configuration, when numbers of scatterers are introduced into a silicon substrate, the scatterers can be easily introduced by an anodic oxidation method and an annealing process.

In the silicon solar cell of the present invention, it is desirable that the cavity be filled with a gas or be in a vacuum state.

According to this configuration, a scatterer having a different refractive index than a silicon substrate can be easily formed by an anodic oxidation method and an annealing process.

In the silicon solar cell of the present invention, it is desirable that a surface of the cavity be covered with a silicon oxide film.

According to this configuration, the effect of preventing rebonding of silicon at the surface of the cavity can be obtained.

In the silicon solar cell of the present invention, it is desirable that a maximum diameter of the scatterer be less than 300 nm.

According to this configuration, such light in sunlight that has a wavelength effective in being absorbed by silicon and performing optical excitation can be scattered.

In the silicon solar cell of the present invention, it is desirable that a thickness of the silicon substrate should be 100 $\mu$m or less.

According to this configuration, the effect of introducing a scatterer is high if the thickness of the silicon substrate is 100 $\mu$m or less.

EFFECT OF THE INVENTION

According to the present invention, even if a silicon layer is formed in a thin film form, the light pass-through length after incidence is increased so that light absorption can be increased. By this, a silicon solar cell capable of improving photoelectric conversion efficiency can be provided.

BRIEF DESCRIPTION OF THE DRAWINGS

FIG. 1 is a cross-sectional view of a silicon substrate of a silicon solar cell according to an embodiment of the present invention.

FIG. 2 is a partial cross-sectional view of a silicon substrate for describing an anodic oxidation method.

FIG. 3 is a relationship diagram between a scattering coefficient and the wavelength of light for when the diameter of air spheres is changed in a range from 10 to 150 nm.

FIG. 4 is a relationship diagram between the amount of scattered lights whose scattering angles exceed a critical angle, and the wavelength of light.

FIG. 5 is a first relationship diagram between the amount of absorption and wavelength of light for describing an effect of the present embodiment.

FIG. 6 is a second relationship diagram between the amount of absorption and wavelength of light for describing the effect of the present embodiment.

FIG. 7 is a third relationship diagram between the amount of absorption and wavelength of light for describing the effect of the present embodiment.

FIG. 8 is a fourth relationship diagram between the amount of absorption and wavelength of light for describing the effect of the present embodiment.

FIG. 9 is a fifth relationship diagram between the amount of absorption and wavelength of light for describing the effect of the present embodiment.

FIG. 10 is a sixth relationship diagram between the amount of absorption and wavelength of light for describing the effect of the present embodiment.

FIG. 11 is a seventh relationship diagram between the amount of absorption and wavelength of light for describing the effect of the present embodiment.

FIG. 12 is an eighth relationship diagram between the amount of absorption and wavelength of light for describing the effect of the present embodiment.

FIG. 13 is a ninth relationship diagram between the amount of absorption and wavelength of light for describing the effect of the present embodiment.

FIG. 14 is a tenth relationship diagram between the amount of absorption and wavelength of light for describing the effect of the present embodiment.

FIG. 15 is an eleventh relationship diagram between the amount of absorption and wavelength of light for describing the effect of the present embodiment.

FIG. 16 is a twelfth relationship diagram between the amount of absorption and wavelength of light for describing the effect of the present embodiment.

FIG. 17 is a thirteenth relationship diagram between the amount of absorption and wavelength of light for describing the effect of the present embodiment.

FIG. 18 is a fourteenth relationship diagram between the amount of absorption and wavelength of light for describing the effect of the present embodiment.

FIG. 19 is a first table showing the values of current generated, upon incidence of sunlight, in silicon solar cells having silicon substrates with and without air spheres introduced thereinto in the present embodiment.

FIG. 20 is a second table showing the values of current generated, upon incidence of sunlight, in silicon solar cells having silicon substrates with and without air spheres introduced thereinto, when the volume ratio of the air spheres to silicon is fixed in the present embodiment.

FIG. 21 is a third table showing the values of current generated, upon incidence of sunlight, in silicon solar cells having silicon substrates with and without air spheres introduced thereinto, when the volume ratio of the air spheres to silicon is fixed in the present embodiment.

FIG. 22 is a schematic configuration diagram of an anodic oxidation apparatus. FIG. 22(a) is a diagram of the anodic oxidation apparatus as viewed in a direction in which a surface of a silicon substrate 10 is seen. FIG. 22 (b) is a diagram of the anodic oxidation apparatus as viewed in a direction horizontal to the surface of the silicon substrate 10.

FIG. 23 is a cross-sectional view of a silicon substrate of a silicon solar cell according to the embodiment of the present invention.

FIG. 24 is a diagram showing the results of calculation of light absorptances of silicon substrates.

FIG. 25 is a diagram showing the results of actual measurement of light internal survival rates of silicon substrates.

DESCRIPTION OF THE REFERENCE NUMERALS

10: SILICON SOLAR CELL
10a: LIGHT-RECEIVING SURFACE
11: INCIDENT LIGHT
11a to 11g: SCATTERED LIGHT
12: SCATTERER (AIR SPHERE)
13: A HOLE
22: POWER SUPPLY
23: RESIST
24: CATHODE
25: ELECTRODE
t: THICKNESS OF A SILICON SUBSTRATE
L: HORIZONTAL WIDTH OF A SILICON SUBSTRATE
D: DIAMETER OF AIR SPHERES
$\theta_{cri}$: CRITICAL ANGLE
$\theta$: SCATTERING ANGLE

BEST MODE FOR CARRYING OUT THE INVENTION

An embodiment of the present invention will be described with reference to the accompanying drawings. The embodiment which will be described below is examples of the present invention, and the present invention is not limited to the following embodiment. Note that those components denoted by the same reference numerals in the specification and the drawings mutually denote the same components.

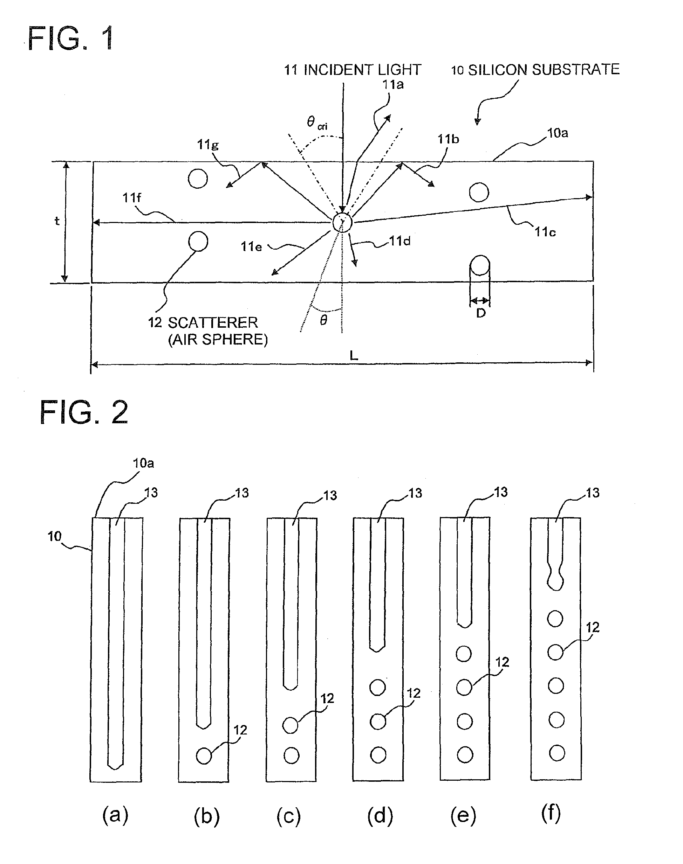

FIG. 1 is a cross-sectional view of a silicon substrate of a silicon solar cell according to the embodiment of the present invention. This silicon substrate 10 is a flat substrate formed of a single crystal silicon material, and forms a pn junction structure where an n-type silicon substrate is formed on a p-type silicon substrate by diffusion of n-type impurities. Note that the silicon solar cell is configured to have a negative electrode, which is not shown, on a light-receiving surface 10a for incident light 11; and a positive electrode, which is not shown, on a surface opposite to the light-receiving surface 10a.

The present embodiment is **characterized in that** numbers of scatterers 12 which scatter the incident light 11 in all directions as shown by a plurality of arrows 11a, 11b, 11c, 11d, 11e, 11f, and 11g, are provided in the silicon substrate 10. Here, $\theta_{cri}$ is the critical angle of the silicon substrate 10 with respect to air, and $\theta$ is the angle of scattered light (scattering angle). Scattered lights shown by the arrows 11a to 11g are such that, when the scattering angle $\theta$ is within the critical angle $\theta_{cri}$, scattered light is emitted from the silicon surface 10 to the outside, as shown by the arrow 11a, and when the scattering angle $\theta$ exceeds the critical angle $\theta_{cri}$, scattered light is totally reflected at the light-receiving surface 10a inside the silicon substrate 10, as shown by the arrows 11b and 11g, or passes through the silicon substrate 10, as shown by the arrows 11c and 11f. Furthermore, though not shown, scattered light may be scattered again by a scatterer 12.

Next, it is assumed that the silicon substrate 10 is formed in a thin film form where the thickness t thereof is 100 $\mu$m or less, and the photosensitivity of the silicon substrate 10 by the incident light 11 is 0.2 $\mu$m to 1.1 $\mu$m. Even if the silicon substrate 10 is thus formed in a thin film form, by allowing the incident light 11 to be scattered in the silicon substrate 10 by the scatterers 12, the incident light 11 can be guided in a longitudinal direction along the light-receiving surface 10a, as shown by the arrows 11c and 11f. When the thickness t is 100 $\mu$m or more, the effect of increasing absorption efficiency which is brought about by introducing the scatterers 12 to scatter light thereby decreases. The lower limit on the thickness t is confirmed up to 1 $\mu$m.

Light has characteristics that light is normally reflected at an irradiation surface of an object but when the size of the object is smaller than the wavelength of the light, the light irradiated onto the object is scattered in all directions from the object rather than being reflected.

The scatterers 12 use such characteristics, and are defined such that the refractive index thereof differs from that of the silicon substrate 10 and the maximum diameter thereof is smaller than such a wavelength of light in sunlight that is effective in being absorbed by silicon and performing optical excitation.

Furthermore, the form of the scatterers 12 is not limited to a spherical shape and may have a projected and recessed surface, a polygonal shape, etc. The form of the scatterers 12 can be any as long as the scatterers 12 are closed cavities and have a gas such as air, oxygen, argon, helium, or nitrogen filled therein to make their refractive index different from that of the silicon substrate 10. Alternatively, the inside of the scatterers 12 may be vacuum. Note that the scatterers 12 may be formed of germanium or silicon oxide.

EXAMPLES

(First Example)

In the present example, as scatterers 12, air spheres 12 forming a spherical shape with a diameter D of less than 300 nm are used. The air spheres 12 may have other forms than a spherical shape, e.g., a cross-section elliptical shape or a projected and recessed surface form, in which case the diameter D = a maximum diameter D. Formation of the air spheres 12 in a silicon substrate 10 is performed by an anodic oxidation method. The anodic oxidation method will be described with reference to a partial cross-sectional view of a silicon substrate for describing an anodic oxidation method which is shown in FIG. 2.

The anodic oxidation method is generally a method for oxidizing electrode metal by electrolysis. Here, a silicon substrate 10 is placed in an electrolytic solution and a voltage of several volts, about 5 to 10 V, is applied with the silicon substrate 10 being an anode + and the electrolytic solution being a cathode -, whereby the silicon substrate 10 being the anode is oxidized. By this oxidization, holes are randomly made in a surface of the silicon substrate 10 serving as a light-receiving surface 10a, and the holes are developed in a downward direction of the substrate with the spacings between the holes and their respective adj acent holes being maintained, whereby elongated holes 13 of about 10 to 100 μm are made in several minutes, as shown in FIG. 2(a). Note that FIG. 2(a) to (f) show only one hole 13.

Thereafter, by performing an annealing process on the silicon substrate 10 having the holes 13 made therein at about 800 to 900°C, as shown in FIG. 2(b) to (f), air spheres 12 in which air is trapped in spherical cavities are arranged in turn from the bottom of the substrate. Alternatively, when the inside of the cavities is made vacuum, oxygen, water, or the like, is placed in the holes 13, whereby a vacuum state is brought about by an annealing process.

By thus introducing numbers of air spheres 12 into the silicon substrate 10 to allow incident light 11 from the light-receiving surface 10a to be scattered by the air spheres 12, the incident light 11 can be guided in all directions in the silicon substrate 10, as scattered lights, as shown by the arrows 11a to 11g. At this time, since, as shown by the arrows 11c and 11f, scattered lights travel in a long-length direction along the light-receiving surface 10a, the light pass-through length increases correspondingly, enabling to increase light absorption. Accordingly, photoelectric conversion efficiency can be improved.

This effect is verified, as will be described next. Specifically, an increase in absorption of light for when air spheres 12 are introduced into a silicon substrate 10 in the above-described manner is considered.

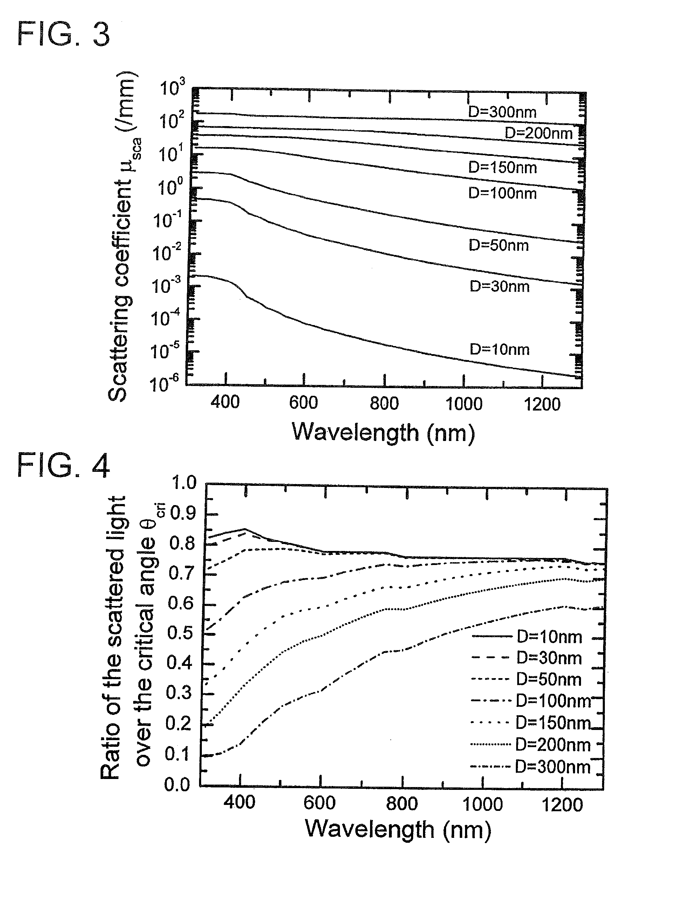

First, the values of scattering coefficients $\mu_{sca}$ for when the diameter D of air spheres 12 is changed in a range from 10 to 300 nm are plotted with respect to the wavelength of light, and relationships therebetween are shown in FIG. 3. Specifically, in FIG. 3, a vertical axis represents the scattering coefficient $\mu_{sca}$ and a horizontal axis represents the wavelength. The refractive index of air is 1, and for the refractive index of silicon substrates 10 a common literature value is used. From the results shown in FIG. 3, it is derived that the larger the diameter D of the air spheres 12 the higher the scattering coefficient $\mu_{sca}$, and thus the scattering coefficient $\mu_{sca}$ is dependent upon the diameter D. However, when the diameter D exceeds 300 nm, the scattering effect brought about by the scatterers 12 decreases. The lower limit on the diameter D is confirmed up to 10 nm.

In addition, an amount of scattered lights whose scattering angles θ exceed the critical angle $\theta_{cri}$ (1 is the total amount of scattering at a certain wavelength) is determined, and a relationship between the amount and the wavelength is shown in FIG. 4. Specifically, in FIG. 4, a vertical axis represents the amount of scattered lights whose scattering angles θ exceed the critical angle $\theta_{cri}$, and a horizontal axis represents the wavelength. Using these obtained scattering coefficients $\mu_{sca}$ and the critical angle $\theta_{cri}$, the amounts of absorption of light are determined using the following equations (i) to (iii), to distinguish the effect brought about by scattering from others.

[Equation 1]

$$(i) \qquad \{1 - \exp(-\mu_{sca}t)\} \times \int_{\theta > \theta_{cri}} \phi_{sca} d\theta \times \{1 - \exp(-\alpha_{Si}L)\}$$

$$(ii) \qquad \{1 - \exp(-\mu_{sca}t)\} \times \int_{\theta < \theta_{cri}} \phi_{sca} d\theta \times \{1 - \exp(-\alpha_{Si}t)\}$$

$$(iii) \qquad \exp(-\mu_{sca}t) \times \{1 - \exp(-\alpha_{Si}t)\}$$

Note that $\phi_{sca}$ is the intensity of scattered light, θ is the angle of scattered light (scattering angle), $\theta_{cri}$ is the critical angle of the silicon substrate 10 with respect to air, $\alpha_{si}$ is the absorption coefficient (cm$^{-1}$) of the silicon substrate 10, L is the length of the light-receiving surface 10a of the silicon substrate 10 {the horizontal width of the silicon solar cell (10 cm)}, and t is the thickness of the silicon substrate 10 {the thickness ($\mu$m) of the silicon solar cell}. Note that the length of the light-receiving surface 10a of the silicon substrate 10 is also referred to as the horizontal width of the silicon substrate 10.

Equation (i) is an equation for determining an amount of such scattered lights, among lights scattered by the air spheres 12 in the silicon substrate 10, that are totally reflected due to the scattering angle $\theta$ exceeding the critical angle $\theta_{cri}$, and are absorbed by silicon. The terms of the equation from the left respectively represent the proportion of light scattered when passing through the silicon substrate 10, the proportion of scattered light having a scattering angle exceeding the critical angle $\theta_{cri}$ (scattered light that is totally reflected), the integral value of the intensity of scattered light exceeding the critical angle $\theta_{cri}$ (scattered light that is totally reflected) ÷ the integral value of the intensity of scattered light from 0 degree to 360 degrees, and the amount of light absorbed at a horizontal width L = 10 cm of the silicon substrate 10.

Equation (ii) is an equation for determining an amount of such scattered lights, among lights scattered by the air spheres 12 in the silicon substrate 10, that are within the critical angle $\theta_{cri}$ and are absorbed by silicon in a direction of the thickness t. The terms of the equation from the left respectively represent the proportion of light scattered when passing through the silicon substrate 10, the proportion of scattered light having a scattering angle $\theta$ within the critical angle $\theta_{cri}$, the integral value of the intensity of scattered light within the critical angle $\theta_{cri}$ ÷ the integral value of the intensity of scattered light from 0 degree to 360 degrees, and the amount of light absorbed at the thickness t of the silicon substrate 10.

Equation (iii) is an equation for determining an amount of such lights, among lights that are not scattered by the air spheres 12 in the silicon substrate 10, that are absorbed by silicon in the direction of the thickness t. The terms of the equation from the left respectively represent the proportion of light that is not scattered when passing through the silicon substrate 10 and the amount of light absorbed at the thickness t of the silicon substrate 10.

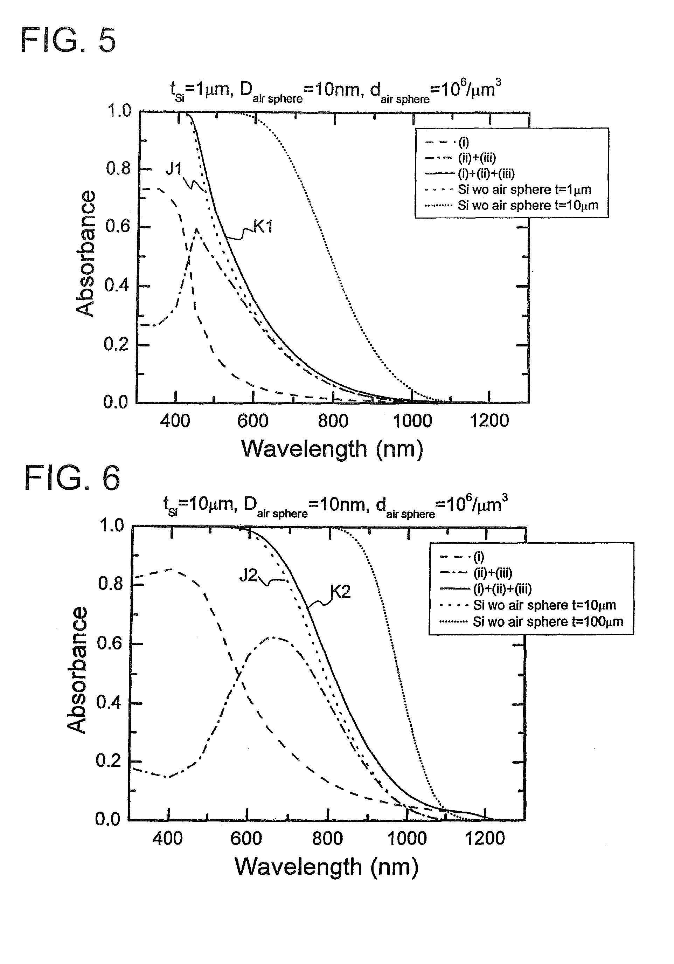

That is, briefly speaking, equation (i) is an equation for determining the amount of absorption by the effect of scattering by the air spheres, and equations (ii) and (iii) are equations for determining the amounts of absorption unrelated to the effect of scattering. The results of determining the amounts of light absorption using these equations (i) to (iii) are shown in FIGS. 5 to 18 by curves. In these drawings, a vertical axis represents the amount of light absorption and a horizontal axis represents the wavelength. In addition, relationships between the amounts of absorption determined by equations (i) to (iii) and the wavelength are shown in the drawings by different curves. Furthermore, Si wo air sphere t=1 $\mu$m, t=10 $\mu$m, and t=100 $\mu$m which are shown in the drawings by different curves than others each indicate a value for when air spheres 12 are not introduced into a silicon substrate 10. The term "wo" is an abbreviation for without.

FIG. 5 shows the results of calculation for determining absorption for when the thickness t of a silicon substrate 10 is 1 $\mu$m and air spheres 12 are contained in the silicon substrate 10. It is assumed that the diameter D of the air spheres 12 is 10 nm, the density d of the air spheres is $10^6/\mu m^3$, and the reflection is zero. As a result, it can be seen that, comparing the case of not introducing air spheres 12 which is shown by a dotted line curve J1 with the case of introducing the air spheres 12 on the above-described conditions which is shown by a solid line curve K1, the amount of light absorption is slightly larger when the air spheres 12 are introduced.

FIG. 6 shows the results of calculation for determining absorption for when the thickness t of a silicon substrate 10 is 10$\mu$m and air spheres 12 are contained in the silicon substrate 10. It is assumed that the diameter D of the air spheres 12 is 10 nm, the density d of the air spheres is $10^6/\mu m^3$, and the reflection is zero. As a result, it can be seen that, comparing the case of not introducing air spheres 12 which is shown by a dotted line curve J2 with the case of introducing the air spheres 12 on the above-described conditions which is shown by a solid line curve K2, the amount of light absorption is slightly larger when the air spheres 12 are introduced.

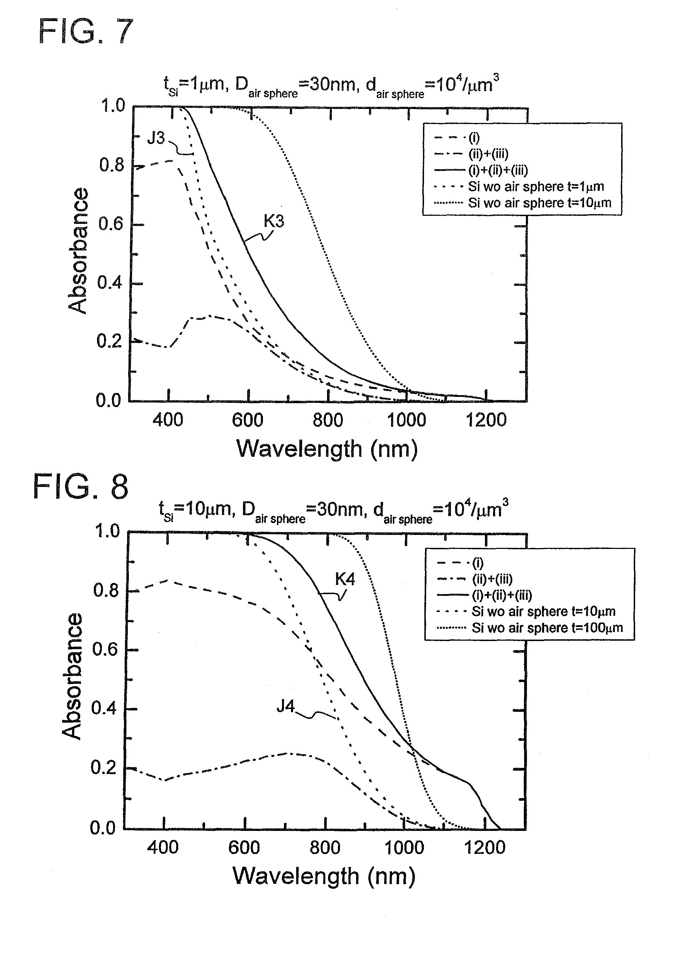

FIG. 7 shows the results of calculation for determining absorption for when the thickness t of a silicon substrate 10 is 1 $\mu$m and air spheres 12 are contained in the silicon substrate 10. It is assumed that the diameter D of the air spheres 12 is 30 nm, the density d of the air spheres is $10^4/\mu m^3$, and the reflection is zero. As a result, it can be seen that, comparing the case of not introducing air spheres 12 which is shown by a dotted line curve J3 with the case of introducing the air spheres 12 on the above-described conditions which is shown by a solid line curve K3, the amount of light absorption is larger when the air spheres 12 are introduced.

FIG. 8 shows the results of calculation for determining absorption for when the thickness t of a silicon substrate 10 is 10 $\mu$m and air spheres 12 are contained in the silicon substrate 10. It is assumed that the diameter D of the air spheres 12 is 30 nm, the density d of the air spheres is $10^4/\mu m^3$, and the reflection is zero. As a result, it can be seen that, comparing the case of not introducing air spheres 12 which is shown by a dotted line curve J4 with the case of introducing the air spheres 12 on the above-described conditions which is shown by a solid line curve K4, the amount of light absorption is larger when the air spheres 12 are introduced.

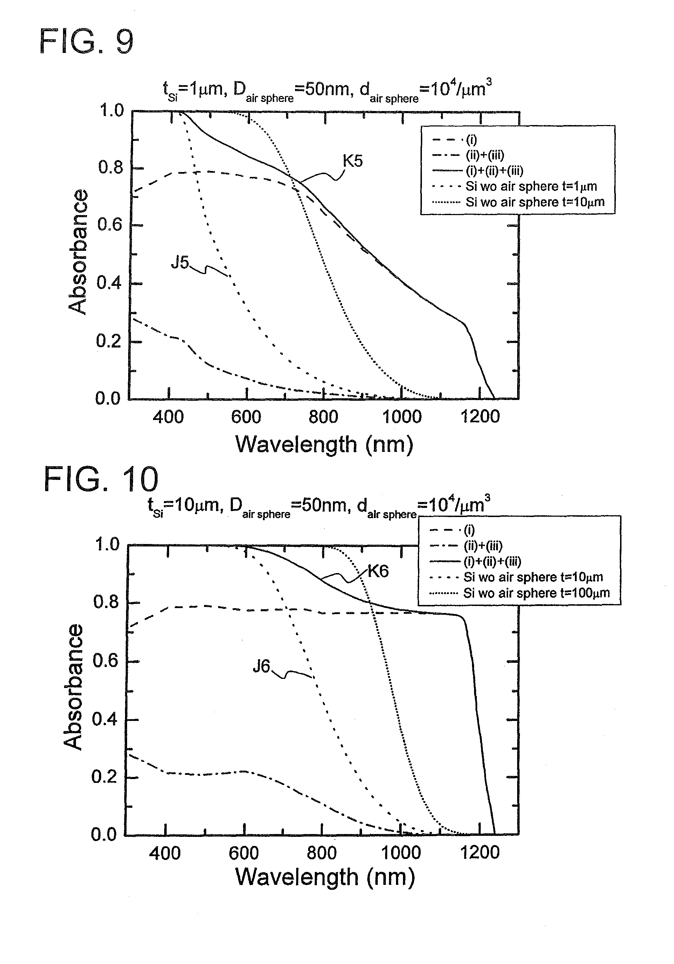

FIG. 9 shows the results of calculation for determining absorption for when the thickness t of a silicon substrate 10 is 1 $\mu$m and air spheres 12 are contained in the silicon substrate 10. It is assumed that the diameter D of the air spheres 12 is 50 nm, the density d of the air spheres is $10^4/\mu m^3$, and the reflection is zero. As a result, it can be seen that, comparing the case of not introducing air spheres 12 which is shown by a dotted line curve J5 with the case of introducing the air spheres 12 on the above-described conditions which is shown by a solid line curve K5, the amount of light absorption is significantly larger when the air spheres 12 are introduced.

FIG. 10 shows the results of calculation for determining absorption for when the thickness t of a silicon substrate 10 is 10 $\mu$m and air spheres 12 are contained in the silicon substrate 10. It is assumed that the diameter D of the air spheres 12 is 50 nm, the density d of the air spheres is $10^4/\mu m^3$, and the reflection is zero. As a result, it can be seen that, comparing the case of not introducing air spheres 12 which is shown by a dotted line curve J6 with the case of introducing the air spheres 12 on the above-described conditions which is shown by a solid line curve K6, the amount of light absorption is significantly larger when the air spheres 12 are introduced.

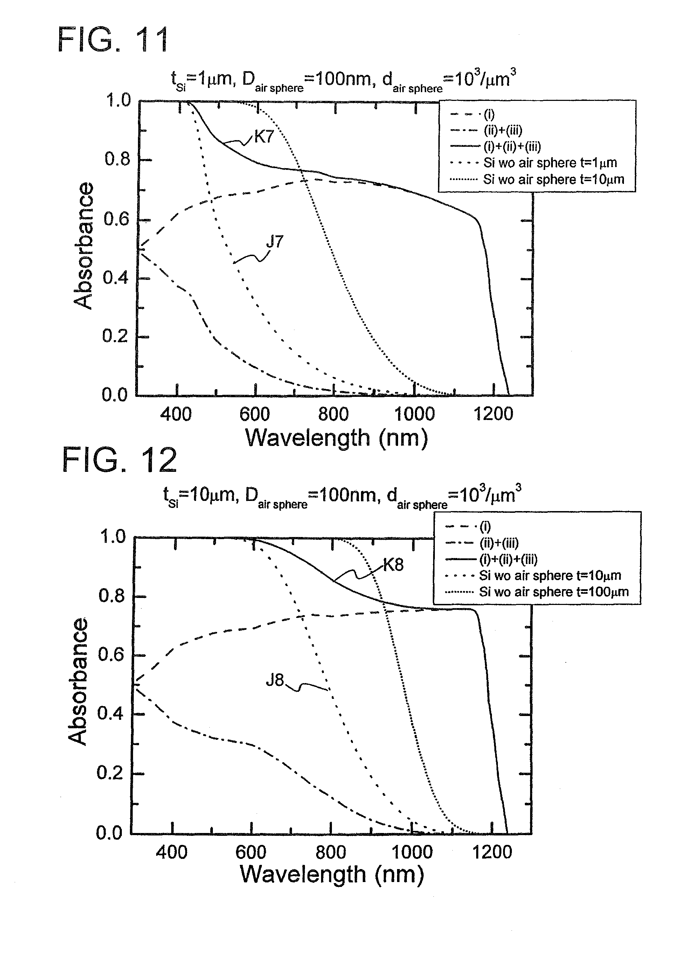

FIG. 11 shows the results of calculation for determining absorption for when the thickness t of a silicon substrate 10 is 1 $\mu$m and air spheres 12 are contained in the silicon substrate 10. It is assumed that the diameter D of the air spheres 12 is 100 nm, the density d of the air spheres is $10^3/\mu m^3$, and the reflection is zero. As a result, it can be seen that, comparing the case of not introducing air spheres 12 which is shown by a dotted line curve J7 with the case of introducing the air spheres 12 on the above-described conditions which is shown by a solid line curve K7, the amount of light absorption is significantly larger when the air spheres 12 are introduced.

FIG. 12 shows the results of calculation for determining absorption for when the thickness t of a silicon substrate 10 is 10 $\mu$m and air spheres 12 are contained in the silicon substrate 10. It is assumed that the diameter D of the air spheres 12 is 100 nm, the density d of the air spheres is $10^3/\mu m^3$, and the reflection is zero. As a result, it can be seen that, comparing the case of not introducing air spheres 12 which is shown by a dotted line curve J8 with the case of introducing the air spheres 12 on the above-described conditions which is shown by a solid line curve K8, the amount of light absorption is significantly larger when the air spheres 12 are introduced.

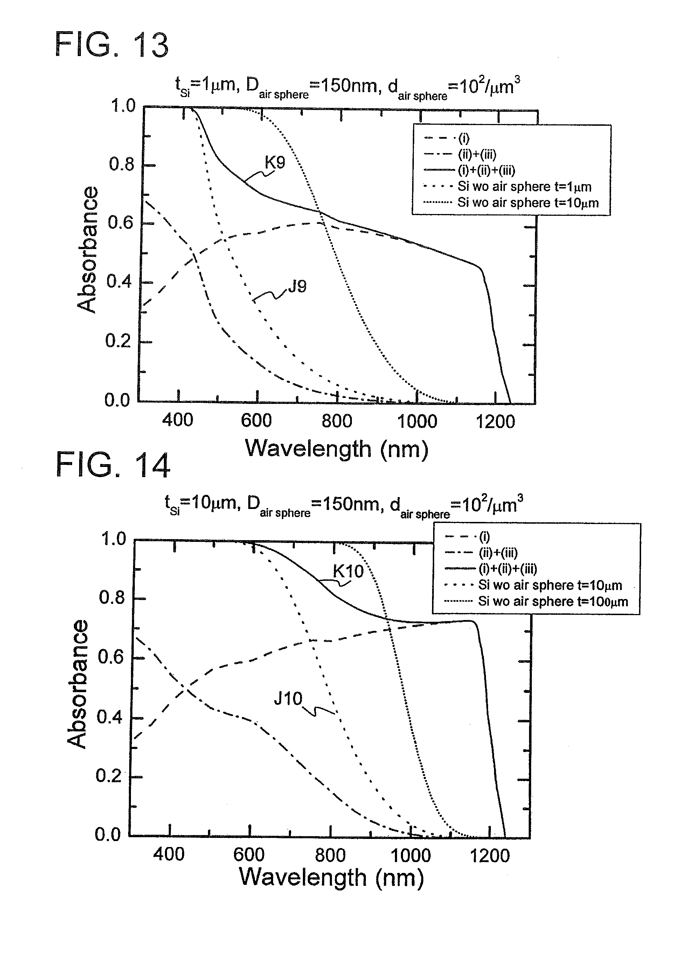

FIG. 13 shows the results of calculation for determining absorption for when the thickness t of a silicon substrate 10 is 1 $\mu$m and air spheres 12 are contained in the silicon substrate 10. It is assumed that the diameter D of the air spheres 12 is 150 nm, the density d of the air spheres is $10^2/\mu m^3$, and the reflection is zero. As a result, it can be seen that, comparing the case of not introducing air spheres 12 which is shown by a dotted line curve J9 with the case of introducing the air spheres 12 on the above-described conditions which is shown by a solid line curve K9, the amount of light absorption is significantly larger when the air spheres 12 are introduced.

FIG. 14 shows the results of calculation for determining absorption for when the thickness t of a silicon substrate 10 is 10 $\mu$m and air spheres 12 are contained in the silicon substrate 10. It is assumed that the diameter D of the air spheres 12 is 150 nm, the density d of the air spheres is $10^2/\mu m^3$, and the reflection is zero. As a result, it can be seen that, comparing the case of not introducing air spheres 12 which is shown by a dotted line curve J10 with the case of introducing the air spheres 12 on the above-described conditions which is shown by a solid line curve K10, the amount of light absorption is significantly larger when the air spheres 12 are introduced.

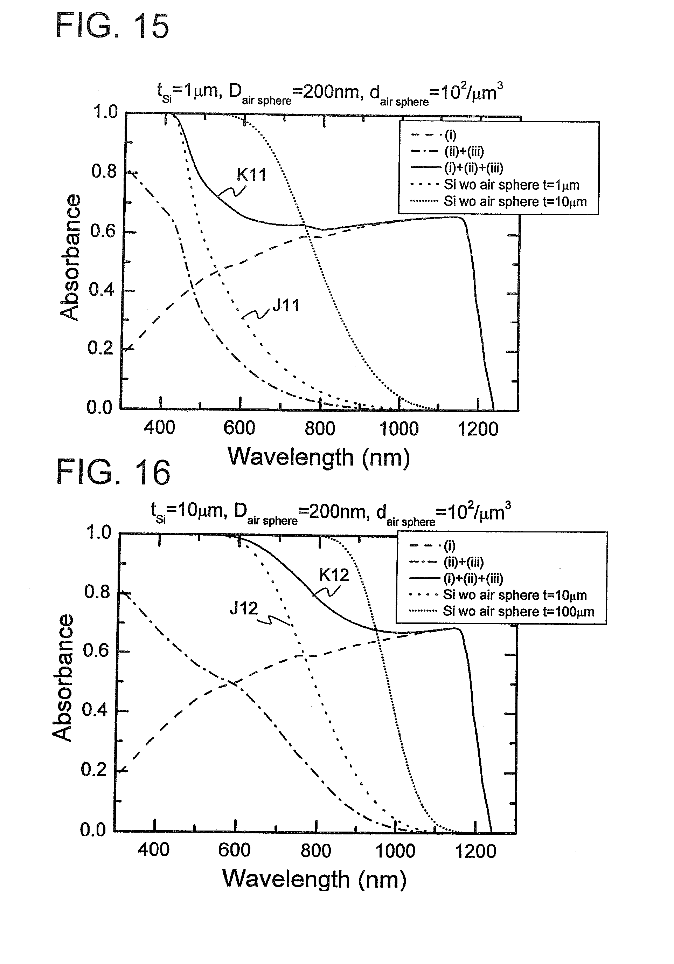

FIG. 15 shows the results of calculation for determining absorption for when the thickness t of a silicon substrate 10 is 1 $\mu$m and air spheres 12 are contained in the silicon substrate 10. It is assumed that the diameter D of the air spheres 12 is 200 nm, the density d of the air spheres is $10^2/\mu m^3$, and the reflection is zero. As a result, it can be seen that, comparing the case of not introducing air spheres 12 which is shown by a dotted line curve J11 with the case of introducing the air spheres 12 on the above-described conditions which is shown by a solid line curve K11, the amount of light absorption is significantly larger when the air spheres 12 are introduced.

FIG. 16 shows the results of calculation for determining absorption for when the thickness t of a silicon substrate 10 is 10 $\mu$m and air spheres 12 are contained in the silicon substrate 10. It is assumed that the diameter D of the air spheres 12 is 200 nm, the density d of the air spheres is $10^2/\mu m^3$, and the reflection is zero. As a result, it can be seen that, comparing the case of not introducing air spheres 12 which is shown by a dotted line curve J12 with the case of introducing the air spheres 12 on the above-described conditions which is shown by a solid line curve K12, the amount of light absorption is significantly larger when the air spheres 12 are introduced.

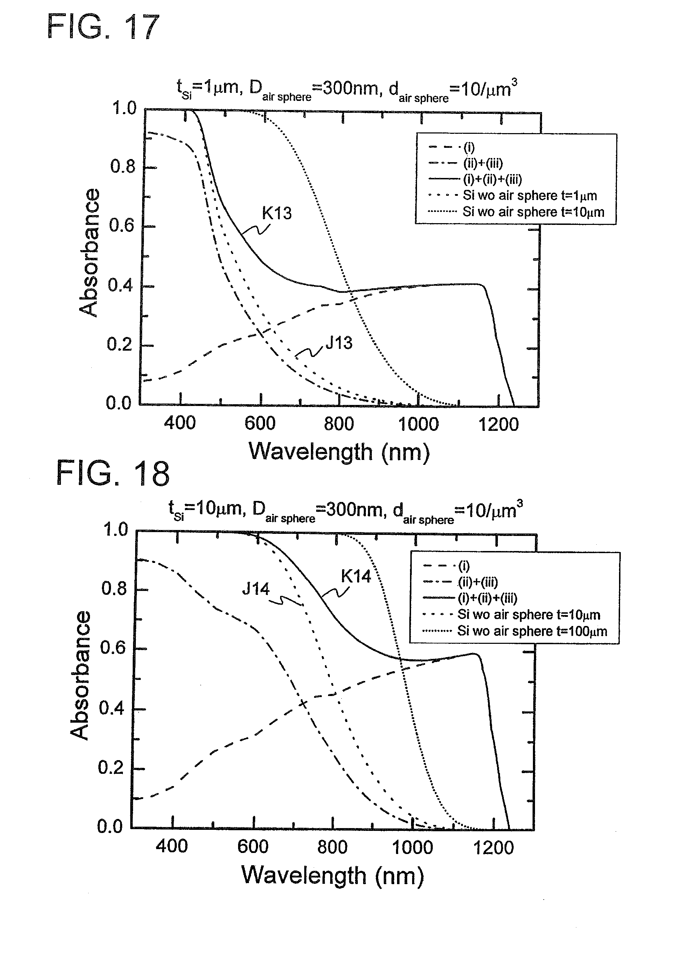

FIG. 17 shows the results of calculation for determining absorption for when the thickness t of a silicon substrate 10 is 1 $\mu$m and air spheres 12 are contained in the silicon substrate 10. It is assumed that the diameter D of the air spheres 12 is 300 nm, the density d of the air spheres is $10/\mu m^3$, and the reflection is zero. As a result, it can be seen that, comparing the case of not introducing air spheres 12 which is shown by a dotted line curve J13 with the case of introducing the air spheres 12 on the above-described conditions which is shown by a solid line curve K13, the amount of light absorption is significantly larger when the air spheres 12 are introduced.

FIG. 18 shows the results of calculation for determining absorption for when the thickness t of a silicon substrate 10 is 10$\mu$m and air spheres 12 are contained in the silicon substrate 10. It is assumed that the diameter D of the air spheres 12 is 300 nm, the density d of the air spheres is $10/\mu m^3$, and the reflection is zero. As a result, it can be seen that, comparing the case of not introducing air spheres 12 which is shown by a dotted line curve J14 with the case of introducing the air spheres 12 on the above-described conditions which is shown by a solid line curve K14, the amount of light absorption is significantly larger when the air spheres 12 are introduced.

That is, as shown by the solid line curves K1 to K14 in FIGS. 5 to 18, it can be seen that as the curve indicating the relationship between the amount of absorption and the wavelength extends further in a horizontal direction, the amount of light absorption increases.

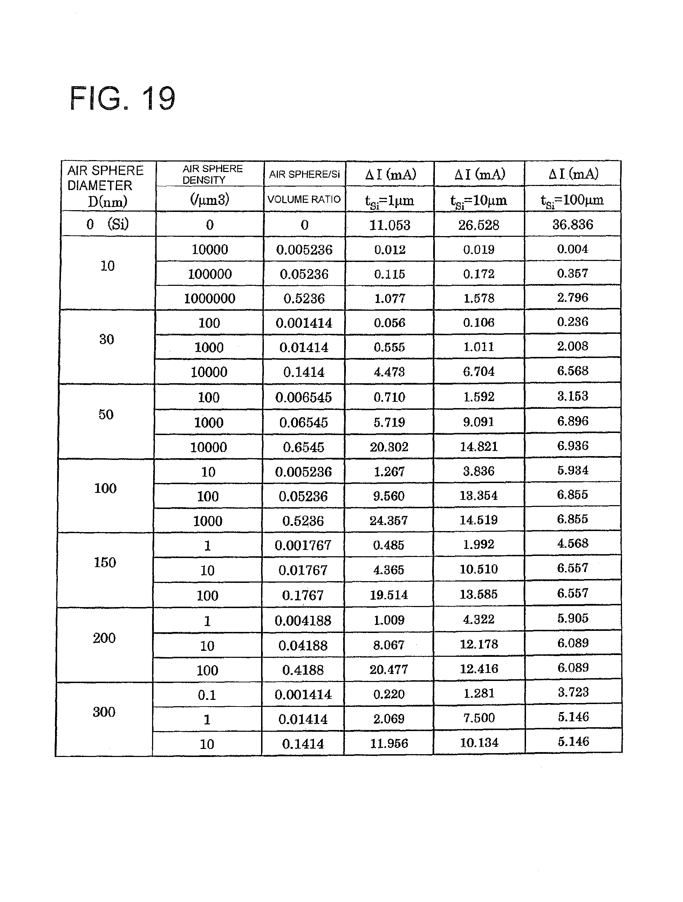

Next, a first table shown in FIG. 19 shows differences in the value of current I generated in silicon solar cells having a silicon substrate 10 with air spheres 12 introduced thereinto and a silicon substrate 10 without air spheres 12 introduced thereinto, when sunlight is incident as incident light 11. Note that calculation of a current value for the case of introducing the air spheres 12 is performed as shown in the following equation (iiii). Note that it is assumed that all of the photons of sunlight are absorbed by the silicon substrate 10 without being reflected at a light-receiving surface 10a, and are measured as a current.

$$(iiii) \qquad I = \int \phi_{solar\ light}(\lambda) \times \{(i) + (ii) + (iii)\} d\lambda$$

Note that $\phi_{solar\ light}$ is sunlight (AM1.5g; the standard terrestrial solar spectrum for temperature latitudes). Note also that AM1.5g is an abbreviation for air mass 1.5 global.

In the first table, fields in the first row where "0 (Si)" is described at the top of the "air sphere diameter D (nm) " column show the current values "11.053", "26.528", and "36.836" for the case of not introducing air spheres 12. Other fields each show a difference in current value between the case of introducing air spheres 12 and the above-described case of not introducing air spheres 12. For example, in the "ΔI (mA) and t=1 $\mu$m" column, since the current value for the case of not introducing air spheres 12 is "11.053", as shown in the second row, the current value for the case of introducing air spheres 12 with a diameter D = 10 nm at a density of $10^4/\mu m^3$ is the value "11.065" which is obtained by adding "0.012" to "11.053".

From this fact, as shown in the "ΔI (mA) and t=1 $\mu$m" column and the "ΔI (mA) and t=1 $\mu$m" column, it is verified that the current value remarkably increases when air spheres 12 with a diameter D = 50 nm are introduced into a silicon substrate 10 at a density of $10^4/\mu m^3$, when air spheres 12 with a diameter D = 100 nm are introduced into a silicon substrate 10 at a density of $10^3/\mu m^3$, when air spheres 12 with a diameter D = 150 nm are introduced into a silicon substrate 10 at a density of $10^2/\mu m^3$, when air spheres 12 with a diameter D = 200 nm are introduced into a silicon substrate 10 at a density of $10^2/\mu m^3$, and when air spheres 12 with a diameter D = 300 nm are introduced into a silicon substrate 10 at a density of $10/\mu m^3$.

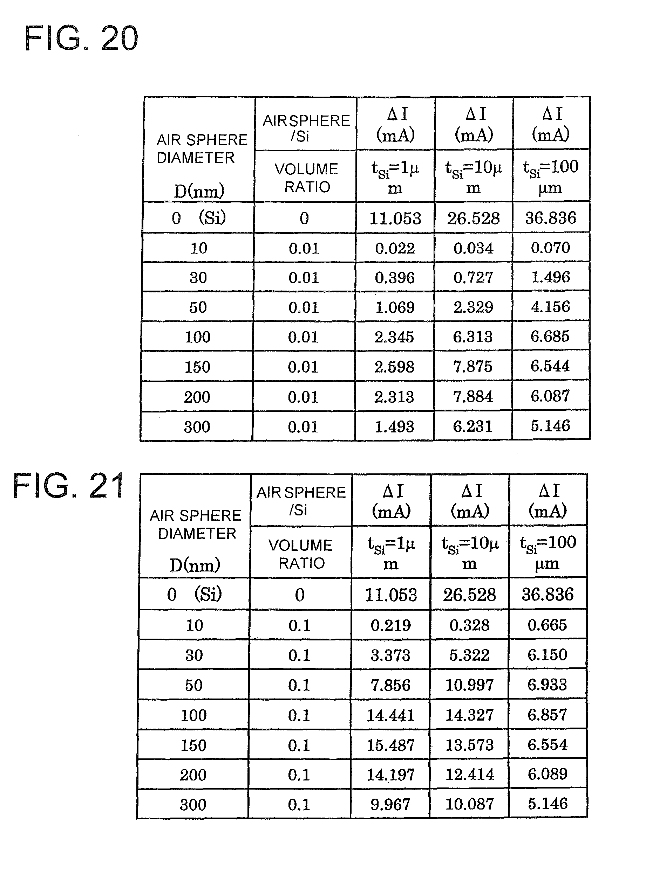

Next, a second table shown in FIG. 20 shows differences in current value which is obtained when the volume ratio of air spheres 12 to silicon is fixed. Note that it shows the differences in current value between the case of introducing air spheres 12 into a silicon substrate 10 at a volume ratio of 0.01 (=1%) and the case of not introducing air spheres 12. Other conditions are the same as those described for the above-described first table.

From the results shown in the second table, it is confirmed that, when the volume ratio is 0.01, a silicon substrate 10 with a thickness t of 1 $\mu$m takes a maximum value at an air sphere diameter of 150 nm, a silicon substrate 10 with a thickness t of 10 $\mu$m takes a maximum value at an air sphere diameter of 200 nm, and a silicon substrate 10 with a thickness t of 100 $\mu$m takes a maximum value at an air sphere diameter of 100 nm.

A third table shown in FIG. 21 shows differences in current value I obtained when the volume ratio of air spheres 12 to silicon is fixed. Note that it shows the differences in current value between the case of introducing air spheres 12 into a silicon substrate 10 at a volume ratio of 0.1 (=10%) and the case of not introducing air spheres 12. Other conditions are the same as those described for the above-described first table.

From the results shown in the third table, it is confirmed that, when the volume ratio is 0.1, a silicon substrate 10 with a thickness t of 1 $\mu$m takes a maximum value at an air sphere diameter of 150 nm, a silicon substrate 10 with a thickness t of 10 $\mu$m takes a maximum value at an air sphere diameter of 100 nm, and a silicon substrate 10 with a thickness t of 100 $\mu$m takes a maximum value at an air sphere diameter of 50 nm.

As such, according to the present embodiment, by introducing numbers of air spheres 12 into a silicon substrate 10 taking into account the diameter D and introduction density of the air spheres 12, incident light 11 from a light-receiving surface 10a can be scattered by the air spheres 12 and the scattered lights can be guided in all directions in the substrate. At this time, since scattered lights travel in a long-length direction along the light-receiving surface 10a, the light pass-through length can be increased correspondingly. Since, even if the silicon substrate 10 is formed in a thin film form, the length in a longitudinal direction along the light-receiving surface 10a remains long as ever, the light pass-through length after the incident light 11 is incident on the silicon substrate 10 can be increased by the scattered lights. By this, light absorption is increased, enabling to improve photoelectric conversion efficiency.

In addition, although in the above description the case in which a surface of a silicon substrate 10 is flat is assumed, forms adopted in light-trapping techniques such as a sawtooth surface structure and a projected and recessed surface structure which are conventional art may be adopted. Note, however, that a flat surface has an advantage in that manufacturing is easy. In addition, although in the present embodiment a crystalline silicon material is used for a substrate, an amorphous silicon material may be used. In addition to silicon, even with other semiconductor materials, the above-described effect can be obtained by introducing scatterers. Furthermore, scatterers 12 are cavities and there is no particular regularity in the introduction of the scatterers 12 into a substrate. Thus, even with random introduction, the effect can be obtained as with the above.

Moreover, when a surface of a cavity forming a scatterer 12 is covered with a silicon oxide film (SiO$_2$), the effect of preventing rebonding of silicon at the surface of the cavity can be obtained. When the silicon oxide film is formed, an annealing process is performed in an oxidizing atmosphere. At this time, oxygen is deposited, resulting in the surface of the cavity being covered by an oxide film.

In addition, although the present embodiment is premised on a configuration in which scatterers 12 are introduced into a silicon substrate 10 which forms a pn junction structure where an n-type silicon substrate is formed on a p-type silicon substrate by diffusion of n-type impurities, a configuration may be employed in which scatterers 12 are introduced into a silicon substrate 10 which forms a pn junction structure where a p-type silicon substrate is formed on an n-type silicon substrate by diffusion of p-type impurities. Alternatively, a configuration may be employed in which scatterers 12 are introduced into either one of n- and p-type silicon substrates or an n- and p-type interface.

(Second Example)

Another method of forming air spheres 12 into a silicon substrate 10 will be described. The forming method includes an ion implantation process where ion implantation is performed on a silicon substrate 10; an anodic oxidation process where the silicon substrate 10 is subjected to anodic oxidation; and an annealing process where a heat treatment is performed. In the present example, a p$^+$Si wafer is used as the silicon substrate 10.

In an ion implantation process, ions serving as acceptors are implanted into a surface serving as a light-receiving surface 10a. For example, the ions serving as acceptors are boron ions. It is known that the distance W along air spheres 12 is determined by acceptor density $N_A$, as shown in equation 3 (see, for example, Non-Patent Document 1).

[Equation 3]

$$W = \sqrt{\frac{2\varepsilon_{Si}\varepsilon_0}{q} \cdot \frac{(V_D - V)}{N_A}}$$

where $\varepsilon_{Si}$ is the permittivity of silicon, $\varepsilon_0$ is the permittivity of vacuum, q is the elementary charge, $V_D$ is the diffusion potential that forms a depletion layer, and V is the applied voltage.

In the present example, an ion implantation process consisting of three steps such as those shown below is performed.

(First step) Energy is 150 keV and the amount of implantation is 1.80 E$^{+14}$cm$^{-2}$
(Second step) Energy is 100 keV and the amount of implantation is 1.50 E$^{+14}$cm$^{-2}$
(Third step) Energy is 40 keV and the amount of implantation is 1.10 E$^{+14}$cm$^{-2}$

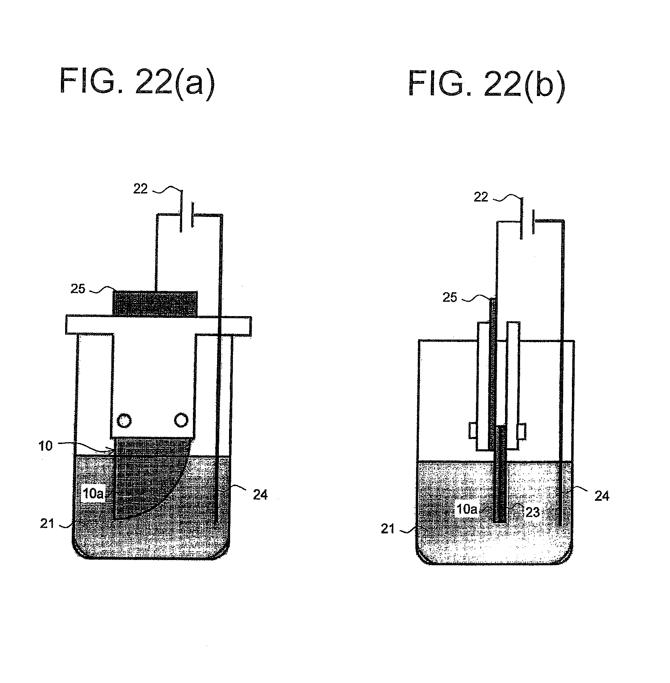

In an anodic oxidation process, anodic oxidation is performed on the ion-implanted silicon substrate 10. First, a resist 23 is applied so as to prevent an ion-implanted surface and a surface on the opposite side thereto from being subjected to anodic oxidation. The anodic oxidation is performed with the silicon substrate 10 being an anode and an electrolytic solution being a cathode. FIG. 22 is a schematic configuration diagram of an anodic oxidation apparatus performed in the present example. FIG. 22(a) is a diagram of the anodic oxidation apparatus as viewed in a direction in which a surface of the silicon substrate 10 is seen. FIG. 22(b) is a diagram of the anodic oxidation apparatus as viewed in a direction horizontal to the surface of the silicon substrate 10.

In the present example, an electrolytic solution 21 is a mixed solution of hydrofluoric acid and ethanol and the volume ratio therebetween is 1:1. As a cathode 24, platinum is used. The silicon substrate 10 and a power supply 22 are connected to each other by an electrode 25. Anodic oxidation is performed for 60 seconds with the voltage between the anode and the cathode being maintained at 16.2 V to 16.3 V and the current density of the surface of the silicon substrate 10 being maintained at 30 mA/cm$^2$ by the power supply 22. In the anodic oxidation process, holes are randomly made in the surface of the silicon substrate 10 serving as the light-receiving surface 10a, and the holes grow in an inward direction of the silicon substrate 10 from the light-receiving surface 10a as the holes are deflected. The depth of the holes, i.e., the depth at which air spheres 12 are formed, can be determined by the voltage between the anode and the cathode, the current density of the surface, and anodic oxidation time.

After the anodic oxidation process, an annealing process where an annealing process is performed on conditions such as those described in the first example is performed. In the annealing process, the holes made in the silicon substrate 10 are formed into air spheres 12 in which air is trapped in spherical cavities, in turn from the inner side of the substrate 10. Alternatively, when the inside of the cavities is made vacuum, oxygen, water, or the like, is placed in the holes, whereby a vacuum state is brought about by an annealing process.

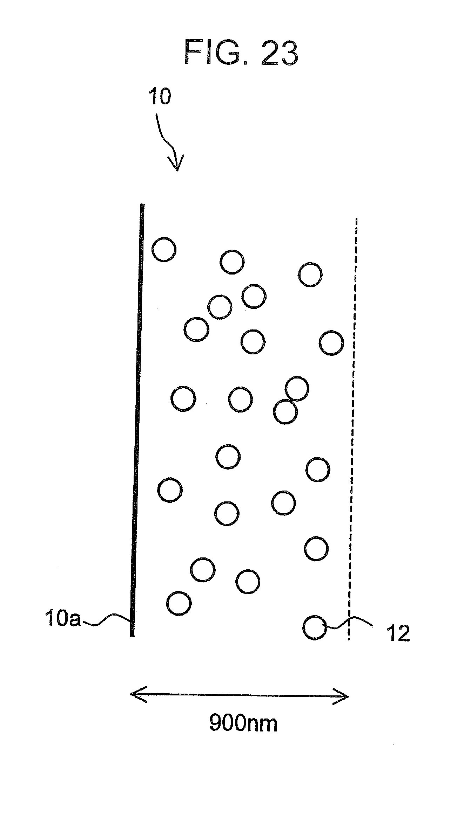

A conceptual diagram of a cross section of the silicon substrate 10 fabricated on the above-described conditions is shown in FIG. 23. The air spheres 12 can be randomly formed to a depth of 900 nm from the light-receiving surface 10a which is the ion implantation side, and the silicon substrate 10 with a thickness t = 900 nm, an average diameter D of the air spheres 12 = 50 nm, and a density d of the air spheres 12 = $10^4/\mu m^3$ can be fabricated. The manufacturing method in the present example allows to form air spheres 12 more randomly in a silicon substrate 10 than the manufacturing method in the first example.

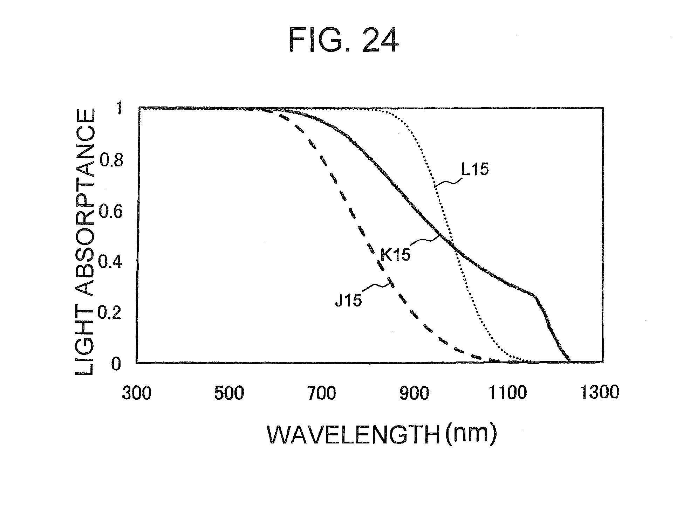

FIG. 24 shows the results of calculation of light absorptances of silicon substrates. A solid line curve K15 shows the result of calculation for determining light absorptance for when the thickness t of a silicon substrate 10 is $10\mu m$ and air spheres 12 are contained in the silicon substrate 10. It is assumed that the diameter D of the air spheres 12 is 50 nm, the density d of the air spheres is $10^4/\mu m^3$, and the reflection is zero. A dashed line curve J15 and a dotted line curve L15 show comparative data. The dashed line curve J15 shows the result of calculation for determining light absorptance of a silicon substrate with a thickness t of 10 $\mu m$ and without air spheres. The dotted line curve L15 shows the result of calculation for determining light absorptance of a silicon substrate with a thickness t of 100 $\mu m$ and without air spheres. As a result, comparing the case of not introducing air spheres 12 which is shown by the dashed line curve J15 with the case of introducing the air spheres 12 on the above-described conditions which is shown by the solid line curve K15, the amount of light absorption is larger when the air spheres 12 are introduced.

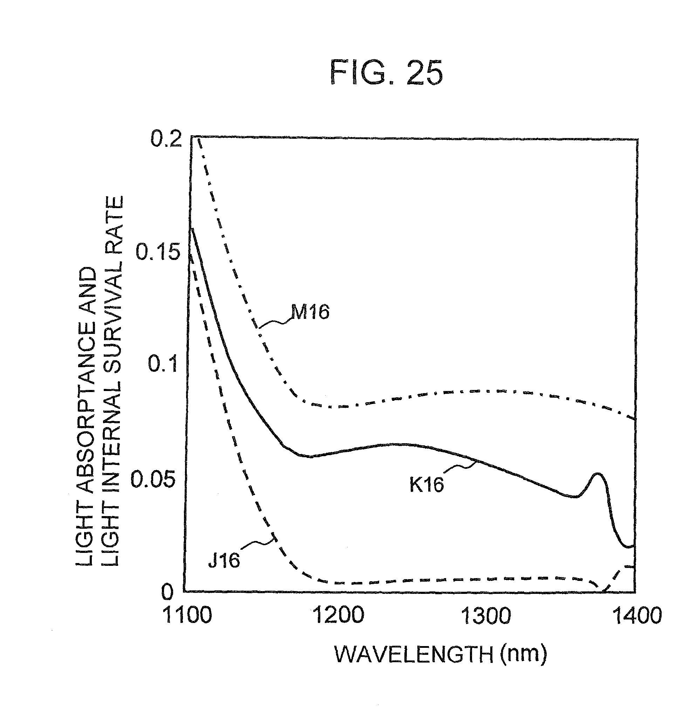

FIG. 25 shows the results of actual measurement of light internal survival rates of silicon substrates. The light internal survival rate is obtained by subtracting the amount of transmitted light and the amount of reflected light from the amount of incident light, and corresponds to the amount of light obtained by summing the amount of light absorbed by the silicon substrate and the amount of light scattered and trapped in the silicon substrate. A solid line curve K16 shows the light internal survival rate of a silicon substrate 10 having air spheres 12. A dash-dotted line curve M16 shows the light internal survival rate of a silicon substrate 10 fabricated in the present example. A dashed line curve J16 shows comparative data and shows actual measurement data of the light internal survival rate of a silicon substrate with a thickness t = 900 nm and without air spheres.

The light absorption edge of silicon is near a wavelength of 1200 nm. In a region with a wavelength of 1200 nm or less, the light internal survival rates of all of the silicon substrates increase due to light absorption. On the other hand, in a region with a wavelength of 1200 nm or more, the light internal survival rate of the silicon substrate without air spheres is substantially zero, from which it can be seen that almost all light is reflected or transmitted and thus does not remain inside. However, in the case of the silicon substrates 10 having the air spheres 12, since light is scattered by the air spheres 12 and remains inside, the light internal survival rates are on the order of 10%. In the silicon substrate 10 formed in the present example, the air spheres 12 are randomly formed and thus the light internal survival rate is higher.

A pn junction structure may be formed on a silicon substrate 10 by diffusion of n-type impurities, whereby a solar cell can be formed. Alternatively, a solar cell may be fabricated by preparing in advance a silicon substrate 10 forming a pn junction structure and introducing scatterers 12 into a p-type region.

Note that although in the present example description is made with a silicon substrate 10 in which air spheres 12 are formed in an annealing process, the same results can be obtained even with a silicon substrate 10 that is not subjected to an annealing process. Specifically, even with holes (pipe-like holes) made in a light-receiving surface 10a of a silicon substrate 10 after an anodic oxidation process, as with a silicon substrate 10 having air spheres 12, the light internal survival rate can be increased more than that of a normal silicon substrate. By a simpler manufacturing method where an annealing process is omitted, a silicon substrate having a light internal survival rate comparable with that of a silicon substrate having air spheres can be manufactured.

INDUSTRIAL APPLICABILITY

Silicon solar cells of the present invention eliminate the need for a battery change or a feeder and thus can achieve an improvement in convenience and a reduction in cost. The silicon solar cells can be applied to common electric and electronic apparatuses such as calculators, watches, road signs, garden lights, street lights, and parking ticket issuing machines, and can be further applied to energy sources in locations where it is difficult or impossible to perform power supply from other locations, e.g., observation equipment in oceanic and mountainous regions, artificial satellites, space stations, and electric and electronic apparatuses in remote islands, areas with poor transmission networks, etc.

**Claims**

1. A silicon solar cell having a silicon substrate of a pn junction structure that converts incident light into electric power, the silicon solar cell comprising:

   a scatterer that scatters incident light in all directions, in the silicon substrate.

2. The silicon solar cell according to claim 1, wherein the scatterer is a cavity.

3. The silicon solar cell according to claim 2, wherein the cavity is filled with a gas or is in a vacuum state.

4. The silicon solar cell according to claim 2 or 3, wherein a surface of the cavity is covered with a silicon oxide film.

5. The silicon solar cell according to claim 1, wherein a maximum diameter of the scatterer is less than 300 nm.

6. The silicon solar cell according to any one of claims 1 to 5, wherein a thickness of the silicon substrate is 100 $\mu$m or less.

FIG. 1

11 INCIDENT LIGHT
10 SILICON SUBSTRATE
11a
11g
11b
10a
$\theta_{cri}$
11f
11c
t
11e
11d
12 SCATTERER
(AIR SPHERE)
$\theta$
D
L

FIG. 2

10a
13
10
13
13
13
13
13
12
12
12
12
12
12

(a)     (b)     (c)     (d)     (e)     (f)

# FIG. 3

# FIG. 4

## FIG. 5

$t_{Si}=1\mu m$, $D_{air\ sphere}=10nm$, $d_{air\ sphere}=10^6/\mu m^3$

Legend:
- – – · (i)
- – · – (ii)+(iii)
- —— (i)+(ii)+(iii)
- · · · · Si wo air sphere t=1μm
- ········ Si wo air sphere t=10μm

J1, K1

Absorbance (0.0 – 1.0) vs Wavelength (nm) (400 – 1200)

## FIG. 6

$t_{Si}=10\mu m$, $D_{air\ sphere}=10nm$, $d_{air\ sphere}=10^6/\mu m^3$

Legend:
- – – · (i)
- – · – (ii)+(iii)
- —— (i)+(ii)+(iii)
- · · · · Si wo air sphere t=10μm
- ········ Si wo air sphere t=100μm

J2, K2

Absorbance (0.0 – 1.0) vs Wavelength (nm) (400 – 1200)

## FIG. 7

$t_{Si}=1\mu m$, $D_{air\ sphere}=30nm$, $d_{air\ sphere}=10^4/\mu m^3$

Legend:
- — · — (i)
- — · · — (ii)+(iii)
- —— (i)+(ii)+(iii)
- · · · · Si wo air sphere t=1μm
- ········ Si wo air sphere t=10μm

## FIG. 8

$t_{Si}=10\mu m$, $D_{air\ sphere}=30nm$, $d_{air\ sphere}=10^4/\mu m^3$

Legend:
- — — (i)
- — · — (ii)+(iii)
- —— (i)+(ii)+(iii)
- · · · · Si wo air sphere t=10μm
- ········ Si wo air sphere t=100μm

# FIG. 9

$t_{Si}=1\mu m$, $D_{air\ sphere}=50nm$, $d_{air\ sphere}=10^4/\mu m^3$

# FIG. 10

$t_{Si}=10\mu m$, $D_{air\ sphere}=50nm$, $d_{air\ sphere}=10^4/\mu m^3$

# FIG. 11

$t_{Si}$=1μm, $D_{air\ sphere}$=100nm, $d_{air\ sphere}$=10³/μm³

# FIG. 12

$t_{Si}$=10μm, $D_{air\ sphere}$=100nm, $d_{air\ sphere}$=10³/μm³

## FIG. 13

$t_{Si}=1\mu m$, $D_{air\ sphere}=150nm$, $d_{air\ sphere}=10^2/\mu m^3$

## FIG. 14

$t_{Si}=10\mu m$, $D_{air\ sphere}=150nm$, $d_{air\ sphere}=10^2/\mu m^3$

## FIG. 15

$t_{Si}=1\mu m$, $D_{air\,sphere}=200nm$, $d_{air\,sphere}=10^2/\mu m^3$

## FIG. 16

$t_{Si}=10\mu m$, $D_{air\,sphere}=200nm$, $d_{air\,sphere}=10^2/\mu m^3$

## FIG. 17

$t_{Si}=1\mu m$, $D_{air\ sphere}=300nm$, $d_{air\ sphere}=10/\mu m^3$

Legend:
- - - (i)
-·-·- (ii)+(iii)
——— (i)+(ii)+(iii)
····· Si wo air sphere t=1μm
·········· Si wo air sphere t=10μm

## FIG. 18

$t_{Si}=10\mu m$, $D_{air\ sphere}=300nm$, $d_{air\ sphere}=10/\mu m^3$

Legend:
- - - (i)
-·-·- (ii)+(iii)
——— (i)+(ii)+(iii)
····· Si wo air sphere t=10μm
·········· Si wo air sphere t=100μm

# FIG. 19

| AIR SPHERE DIAMETER D(nm) | AIR SPHERE DENSITY (/μm3) | AIR SPHERE/Si VOLUME RATIO | $\Delta I$ (mA) $t_{Si}$=1μm | $\Delta I$ (mA) $t_{Si}$=10μm | $\Delta I$ (mA) $t_{Si}$=100μm |
|---|---|---|---|---|---|
| 0 (Si) | 0 | 0 | 11.053 | 26.528 | 36.836 |
| 10 | 10000 | 0.005236 | 0.012 | 0.019 | 0.004 |
| | 100000 | 0.05236 | 0.115 | 0.172 | 0.357 |
| | 1000000 | 0.5236 | 1.077 | 1.578 | 2.796 |
| 30 | 100 | 0.001414 | 0.056 | 0.106 | 0.236 |
| | 1000 | 0.01414 | 0.555 | 1.011 | 2.008 |
| | 10000 | 0.1414 | 4.473 | 6.704 | 6.568 |
| 50 | 100 | 0.006545 | 0.710 | 1.592 | 3.153 |
| | 1000 | 0.06545 | 5.719 | 9.091 | 6.896 |
| | 10000 | 0.6545 | 20.302 | 14.821 | 6.936 |
| 100 | 10 | 0.005236 | 1.267 | 3.836 | 5.934 |
| | 100 | 0.05236 | 9.560 | 13.354 | 6.855 |
| | 1000 | 0.5236 | 24.357 | 14.519 | 6.855 |
| 150 | 1 | 0.001767 | 0.485 | 1.992 | 4.568 |
| | 10 | 0.01767 | 4.365 | 10.510 | 6.557 |
| | 100 | 0.1767 | 19.514 | 13.585 | 6.557 |
| 200 | 1 | 0.004188 | 1.009 | 4.322 | 5.905 |
| | 10 | 0.04188 | 8.067 | 12.178 | 6.089 |
| | 100 | 0.4188 | 20.477 | 12.416 | 6.089 |
| 300 | 0.1 | 0.001414 | 0.220 | 1.281 | 3.723 |
| | 1 | 0.01414 | 2.069 | 7.500 | 5.146 |
| | 10 | 0.1414 | 11.956 | 10.134 | 5.146 |

## FIG. 20

| AIR SPHERE DIAMETER D(nm) | AIR SPHERE /Si VOLUME RATIO | $\Delta I$ (mA) $t_{Si}=1\mu$ m | $\Delta I$ (mA) $t_{Si}=10\mu$ m | $\Delta I$ (mA) $t_{Si}=100$ $\mu$m |
|---|---|---|---|---|
| 0 (Si) | 0 | 11.053 | 26.528 | 36.836 |
| 10 | 0.01 | 0.022 | 0.034 | 0.070 |
| 30 | 0.01 | 0.396 | 0.727 | 1.496 |
| 50 | 0.01 | 1.069 | 2.329 | 4.156 |
| 100 | 0.01 | 2.345 | 6.313 | 6.685 |
| 150 | 0.01 | 2.598 | 7.875 | 6.544 |
| 200 | 0.01 | 2.313 | 7.884 | 6.087 |
| 300 | 0.01 | 1.493 | 6.231 | 5.146 |

## FIG. 21

| AIR SPHERE DIAMETER D(nm) | AIR SPHERE /Si VOLUME RATIO | $\Delta I$ (mA) $t_{Si}=1\mu$ m | $\Delta I$ (mA) $t_{Si}=10\mu$ m | $\Delta I$ (mA) $t_{Si}=100$ $\mu$m |
|---|---|---|---|---|
| 0 (Si) | 0 | 11.053 | 26.528 | 36.836 |
| 10 | 0.1 | 0.219 | 0.328 | 0.665 |
| 30 | 0.1 | 3.373 | 5.322 | 6.150 |
| 50 | 0.1 | 7.856 | 10.997 | 6.933 |
| 100 | 0.1 | 14.441 | 14.327 | 6.857 |
| 150 | 0.1 | 15.487 | 13.573 | 6.554 |
| 200 | 0.1 | 14.197 | 12.414 | 6.089 |
| 300 | 0.1 | 9.967 | 10.087 | 5.146 |

## FIG. 22(a)

## FIG. 22(b)

FIG. 23

900nm

# FIG. 24

FIG. 25

## INTERNATIONAL SEARCH REPORT

International application No.

PCT/JP2009/051804

### A. CLASSIFICATION OF SUBJECT MATTER
*H01L31/04*(2006.01)i

According to International Patent Classification (IPC) or to both national classification and IPC

### B. FIELDS SEARCHED

Minimum documentation searched (classification system followed by classification symbols)
H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 11-307796 A  (Sharp Corp.),<br>05 November, 1999 (05.11.99),<br>Full text; all drawings<br>(Family: none) | 1-3,5-6<br>4 |
| X<br>Y | JP 5-283723 A  (Kaneka Corp.),<br>29 October, 1993 (29.10.93),<br>Full text; all drawings<br>(Family: none) | 1-3,5-6<br>4 |
| X<br>Y | Thin Solid Films, Vol.276, No.1/2(1996),<br>pp.228-230 | 1-3,5-6<br>4 |
| X<br>Y | Solar Energy Materials and Solar Cells, Vol.35,<br>No.1/4(1994), pp.319-324 | 1-3,5-6<br>4 |

☒ Further documents are listed in the continuation of Box C.   ☐ See patent family annex.

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>24 April, 2009 (24.04.09) | Date of mailing of the international search report<br>12 May, 2009 (12.05.09) |
|---|---|
| Name and mailing address of the ISA/<br>Japanese Patent Office | Authorized officer |
| Facsimile No. | Telephone No. |

Form PCT/ISA/210 (second sheet) (April 2007)

28

**INTERNATIONAL SEARCH REPORT**

International application No.

PCT/JP2009/051804

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 6-252428 A  (Sharp Corp.),<br>09 September, 1994 (09.09.94),<br>Par. No. [0005]<br>(Family: none) | 4 |

Form PCT/ISA/210 (continuation of second sheet) (April 2007)

## REFERENCES CITED IN THE DESCRIPTION

**Patent documents cited in the description**

- JP 2006229133 A

- JP 2003331937 A

**Non-patent literature cited in the description**

- **S.M. Sze.** Physics of Semiconductor Devices. John Wiley and Sons, 1969, 370